# EUROPEAN PATENT SPECIFICATION

(11) **EP 1 840 890 B1**
(45) Date of publication and mention of the grant of the patent: **05.08.2009**
(21) Application number: 07100373.5
(22) Date of filing: 11.01.2007
(51) Int. Cl.: G11B 7/125, H01S 5/0683

(54) **Optical disc apparatus and method for performing optical power study thereof**
Optische Plattenvorrichtung und Verfahren zur Durchführung einer optischen Leistungsstudie dafür
Appareil à disque optique et procédé pour effectuer une étude de puissance optique

(30) Priority: 22.02.2006 KR 20060017249
(43) Date of publication of application: 03.10.2007
(73) Proprietor: Samsung Electronics Co., Ltd., Suwon-si, Gyeonggi-Do (KR)
(72) Inventor: Baek, Ji Seon Samsung Electronics Co., Ltd., Suwon-si, Gyonggi-do (KR); Lee, Kyung Geun Samsung Electronics Co., Ltd., Boondang-gu, Seongnam-si, Geyonggi-do (KR); Tatsuhiro, Otsuka Samsung Electronics Co., Ltd., Yeongtong-gu, Suwon-si, Gyeonggi-do (KR)
(74) Representative: Land, Addick Adrianus Gosling

(56) References cited:
- WO-A-20/06072916
- US-A- 5 274 622
- US-A1- 2004 086 006
- US-A1- 2005 013 233
- US-A1- 2005 025 018
- US-A1- 2005 237 885
- US-B1- 6 621 778

## Description

### BACKGROUND OF THE INVENTION

### 1. Field of the Invention

Aspects of the present invention relate to a power control method in an optical disc apparatus, and, more particularly, to an optical disc apparatus and a method for performing an optical power study thereof, which are capable of preventing errors found within a power study result, wherein the errors are generated from a condition that the output power of a laser diode (LD) is saturated at a high temperature, in which the power study detects output characteristics of the LD.

### 2. Description of the Related Art

Generally, an optical disc apparatus records data onto an optical disc using a laser, and plays back data recorded in the optical disc by detecting differences between light intensities. Such an optical disc apparatus includes a laser diode (LD) which outputs a laser beam, corresponding to an optical power control signal, wherein the laser beam scans the optical disc.

The recording layer of an optical disc must be heated at a certain temperature to change a state of phase change materials coating the recording layer so that information can be recorded thereon. Laser output power, which corresponds to the temperature for the recording layer, must be constantly maintained to correctly record data in the recording layer of the optical disc. However, the laser output power changes variously depending on factors such as the types of optical discs used and the environments in which the data is recorded in an optical disc. Therefore, a procedure which searches for optimal recording power must be performed each time the data is recorded in an optical disc.

The laser output power of an LD must be controlled to find out optimal recording power. To this end, output characteristics of the LD must be detected. Specifically, the relationship between an optical power control signal transmitted to the LD and the laser output power transmitted out of the LD must be detected to find out optimal recording power. Therefore, output characteristics of an LD are calculated before searching for an optimal optical power. These calculations are called a "power study."

As the temperature of the LD increases, the optical power of the LD decreases, and vice versa. Power studies are performed to find out characteristics of an LD in order to apply a control signal of a certain range to the LD and then detect a laser output power. However, the power study results will turn up incorrect when the laser output power is saturated, or, in other words, when the power study bases part of its calculations on data in which the laser output power of a laser beam did not change, because the output power of the LD decreases at a relatively high temperature.

These incorrect results become more substantial when a power study is performed by a control signal of low output power.

### SUMMARY OF THE INVENTION

Therefore, it is an aspect of the invention to provide an optical disc and a method for performing an optical power study, which are capable of preventing incorrectness of power study results which may occur because of saturation of output power of an LD at a relatively high temperature, and of precisely performing a power study at a relatively low output power level.

Additional aspects and/or advantages of the invention will be set forth in part in the description which follows and, in part, will be obvious from the description, or may be learned by practice of the invention.

In accordance with the invention, the above and/or other aspects can be achieved by the features defined in the appended claims.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 is a schematic block diagram of an optical disc apparatus according to an embodiment of the present invention;
FIG. 2A is a graph illustrating an ADC level with respect to output power which is outputted from a laser shown in FIG. 1;
FIG. 2B is a graph illustrating output power of the laser with respect to a DAC value;
FIG. 3 is a graph illustrating an ADC level with respect to a DAC value which changes according to temperature;
FIG. 4A is an output waveform outputted while a power study is performed at room temperature;
FIG. 4B is an output waveform outputted while the power study is performed at a high temperature; and
FIG. 5 is a flow chart describing a method for performing the optical power study of an optical disc apparatus according to an embodiment of the present invention.

### DETAILED DESCRIPTION OF THE EMBODIMENTS

Reference will now be made in detail to the present embodiments of the present invention, examples of which are illustrated in the accompanying drawings, wherein like reference numerals refer to the like elements throughout. The embodiments are described below to describe the present invention by referring to the figures.

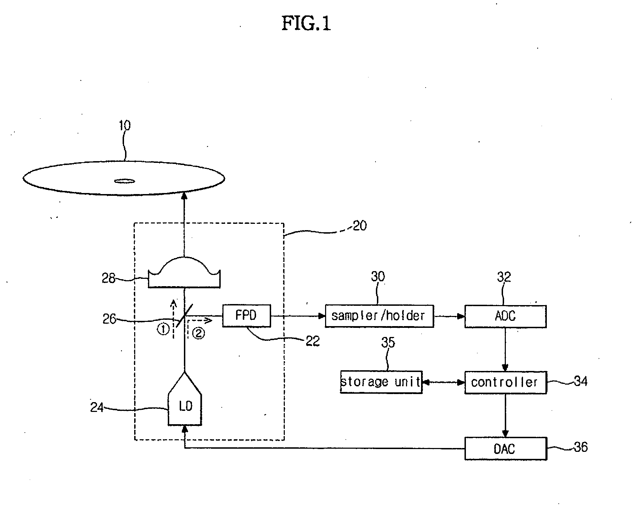

FIG. 1 is a schematic block diagram of an optical disc apparatus according to an embodiment of the present invention. As shown in the drawing, the optical disc apparatus includes an optical pick-up 20 and a sampler/holder 30, an analog/digital converter (ADC) 32, a digital/analog converter (DAC) 36, a controller 34, and a storage unit 35. In this embodiment, the optical pick-up 20 includes an objective lens 28, a beam splitter 26, a laser diode (LD) 24, and a front photo diode (FPD) 22. However, the invention is not limited to this specific embodiment, and it is contemplated that the invention will work with many different configurations.

The optical pick-up 20 scans an optical disc 10 using a laser beam to play back and/or record data from or to the optical disc 10. More specifically, the laser diode LD 24 is an example of a laser output device according to an embodiment of the present invention, which outputs a laser beam according to the optical power control signal. The objective lens 28 focuses the laser beam outputted from the LD 24 on a surface of the optical disc 10. The beam splitter 26 splits the laser beam from the LD 24, directing some of the laser beam into the objective lens, and the rest of the laser beam into the FPD 22, as shown in FIG. 1. The FPD 22 is an example of a sensor according to an embodiment of the present invention, which detects some of the laser beam separated from the beam splitter 26 and outputs a signal corresponding to the laser output power.

The beam splitter 26 separates the laser beam from the LD 24 into a laser beam 1 which is projected towards the optical disc 20, in order to scan the optical disc 10, and a laser beam 2, which is projected towards the FPD 22, in order to detect the laser output power.

The current signal outputted from the FPD 22 of the optical pick-up 20 is converted to a voltage signal and then transmitted to the sampler/holder 30. The sampler/holder 30 performs sampling and holding for the output signal outputted from the FPD 22 to separate it into voltages corresponding to a recording power level, an erase power level, and a bias power level, and then outputs these voltages to the ADC 32.

The ADC (a first converter) 32 converts the voltage corresponding to the erase power level to a digital signal. For example, the ADC 32 divides a certain voltage range into a plurality of digital steps based on a certain resolution, and then converts a voltage in the voltage range into a digital step in the divided plurality of digital steps corresponding to the voltage, respectively. When 0-3.3V is divided on the basis of a resolution of 10bits, 2.5V is converted into 755 digital steps. The converted digital steps of the ADC 32 (which is referred to as an ADC digital step) are transmitted to the controller 34 in such a way that the controller 34 can determine the laser output power of the LD 24. The ADC digital steps may be expressed in various fashions so that the output power of the LD 24 can be analyzed. Of them, ELVL is a difference, in digital steps, between the ADC digital step of the reference voltage and an ADC digital step of current output power. For example, when the reference voltage is 2.5V and a current voltage is 0V, the ELVL is 775 digital steps.

The storage unit 35 includes a read only memory (ROM) in which a control program is previously stored to control operations of the optical disc apparatus, and a random access memory (RAM) which stores various types of data generated while the optical disc apparatus is operated.

The DAC 36 converts the optical power control signal, which is outputted from the controller 34, into an analog signal to output it to the LD 24. The laser output power of the laser beam outputted from the LD 24 changes depending on temperature. The analog signal, which is converted in the DAC 36 according to the optical output control signal of the controller 34, and the laser output power of the laser beam, which is outputted from the LD 24 according to the converted analog signal, have somewhat different characteristics depending on each particular optical disc apparatus. Therefore, a power study procedure is needed to search for output characteristics of laser diodes corresponding to optical power control signals of the controller 34, which depend on characteristics of each optical disc apparatus, as well as characteristics of the LDs 24, which change depending on temperature. The output characteristics of the laser diodes can be expressed as a relationship between a control signal for the laser diode and a corresponding output power of the laser diode. This relationship can be calculated using the control signal and an ADC digital step of a digital signal which is converted from the laser output power of the laser beam according to the control signal.

The controller 34 controls operations of the optical disc apparatus according to a control program stored in the storage unit 35. For example, when a recordable optical disc is inserted into the optical disc apparatus, and a recording command is inputted, the power study procedure for searching for the output characteristics of the LD 24 can be performed, such that the optical disc apparatus can be controlled to perform optimum power calibration (OPC) for detecting optimal recording power.

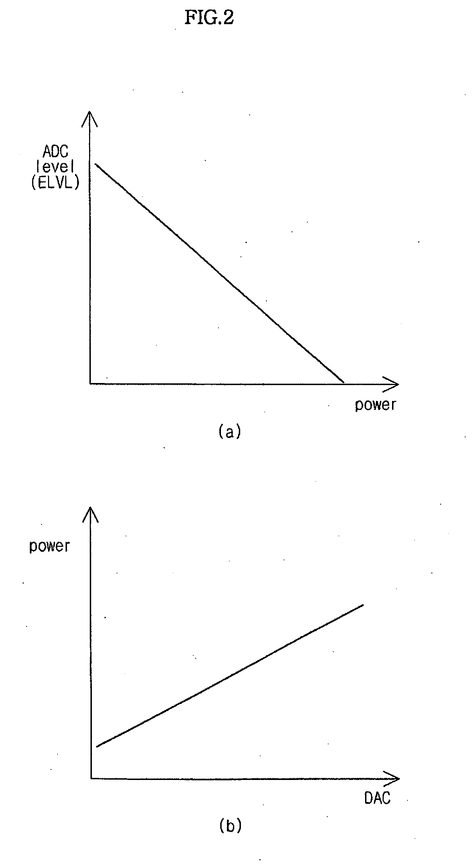

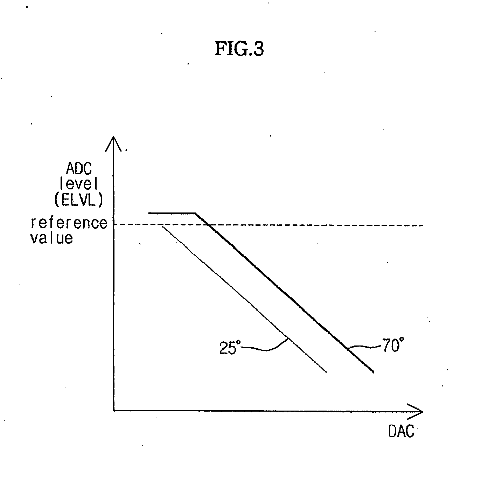

FIG. 2A is a graph illustrating the ADC level with respect to output power which is outputted from a laser shown in FIG. 1, and more specifically, illustrating an ELVL value corresponding to the laser output power of the laser beam outputted from the LD 24. FIG. 2B is a graph illustrating the output power of the laser shown in FIG. 1 with respect to a DAC value, and more specifically, a relationship between signals, which are outputted from the DAC 36 to the LD 24, as compared to the laser output power of the laser beam outputted from the LD 24 in response to the signals of the DAC 24 according to the optical output power control signal of the controller 34. FIG. 3 is a graph illustrating an ADC level with respect to a DAC value which is changed according to temperature.

The following is a description for the power study procedure. Generally, manufacturers manufacture optical disc apparatuses with a pre-set, fixed relationship between the ADC level (ELVL) and the laser output power. In this case, the relationship between the ADC level (ELVL) and the laser output power of the LD 24 of the optical disc apparatus is stored in the storage unit 35. As shown in FIG. 2A, the difference (ELVL) between the laser output power and the ADC level of the reference voltage is reduced according to an increase of the ADC digital step of the laser output power. Therefore, the ADC level (ELVL) forms a linear relationship which is inversely proportional to the laser output power. On the other hand, a relationship for the power study procedure is shown in FIG. 2B.

The ELVL value of FIG. 3, which is detected as an optical power control signal of a certain range, is applied to the LD 24 in the power study procedure. Specifically, the result of the power study, shown in FIG. 2B, can be derived by substituting the data obtained from the graph of FIG. 3 into the relationship shown in FIG. 2A. A predetermined amount of data is required so as to derive a relationship between the precise optical power control signal and the laser power.

Here, the optical power control signal of a certain range preferably corresponds to a control signal corresponding to laser power of an erase power level. Since the power study procedure detects output characteristics of the LD 24, the procedure does not affect the optical disc. Also, when a relatively small power level is used for the power study procedure, the output characteristics of the LD 24 cannot be detected.

Additionally, it is preferable to perform the power study procedure in a state where the optical pick-up 20 is spaced apart, as far as possible, from the optical disc 10.

As shown in FIG. 3, as the temperature increases, the output power of the LD 24 decreases. Therefore, as the optical power control signal is increased, an interval, in which the laser power of the outputted laser beam is almost unchanged, is generated. Specifically, such an interval is generated as the laser diode ages, causing its power to be saturated in that interval. When this interval with saturated power, i.e., saturation interval, is generated, laser power within the interval is almost unchanged for a range of optical power control signals whose ELVL is constant. When a relationship between the optical power control signal and the laser power is calculated using data in this interval, the calculation result includes errors which prevent operations, such as OPC, etc., from being properly performed. Therefore, it is preferable to exclude ELVL data according to the optical power control signal in this saturated interval, when calculating the relationship between the optical power control signal and the laser power.

Since a predetermined amount of data is needed to calculate the relationship resulting from the power study, when the relationship cannot be calculated using data in which data in the saturation portion is not included, the ELVL is measured while the control signal is sequentially changed, again, until sufficient data can be obtained on the basis of the optical power control signal corresponding to the reference value, which is used as a minimum point. At this point, the data obtained through the above procedure is obtained in an area excluding the saturated interval. Therefore, the calculated relationship precisely reflects the output characteristics of the laser diode installed in the optical pick-up.

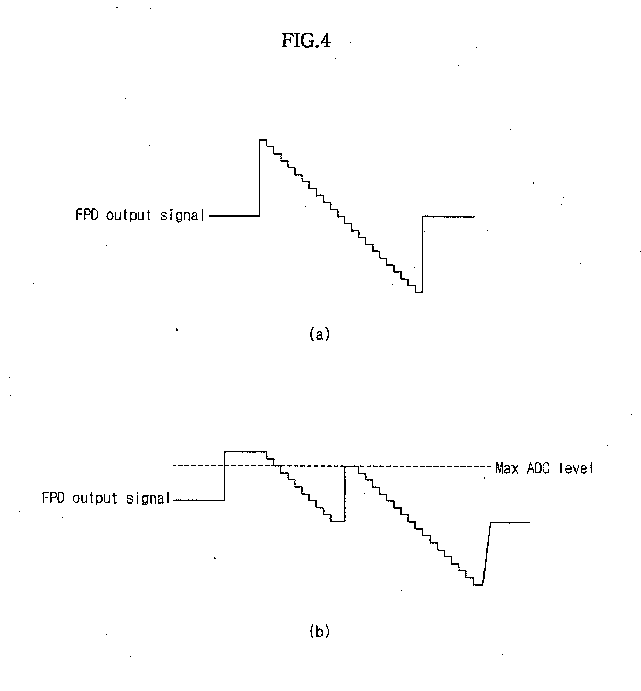

FIG. 4A is an output waveform outputted while a power study is performed at room temperature, and more specifically, an output waveform of the FPD according to a change of a control signal in the normal power study procedure. When the power of a laser diode is not saturated at room temperature and by laser diode aging, the power study procedure is performed as shown in FIG. 4A. FIG. 4B is an output waveform outputted while a power study is performed at a high temperature. As shown in FIG. 4B, there exists a saturated portion, represented by the portion of the FDR output signal above the Max ADC level dotted line. In this case, since the data excluding the data in the saturation portion is not sufficient to calculate the relationship, the output power of the FPD is detected as a control signal and then is changed, again, on the basis of an optical power control signal corresponding to a reference value (Max ADC level), which is used as the minimum point thereof.

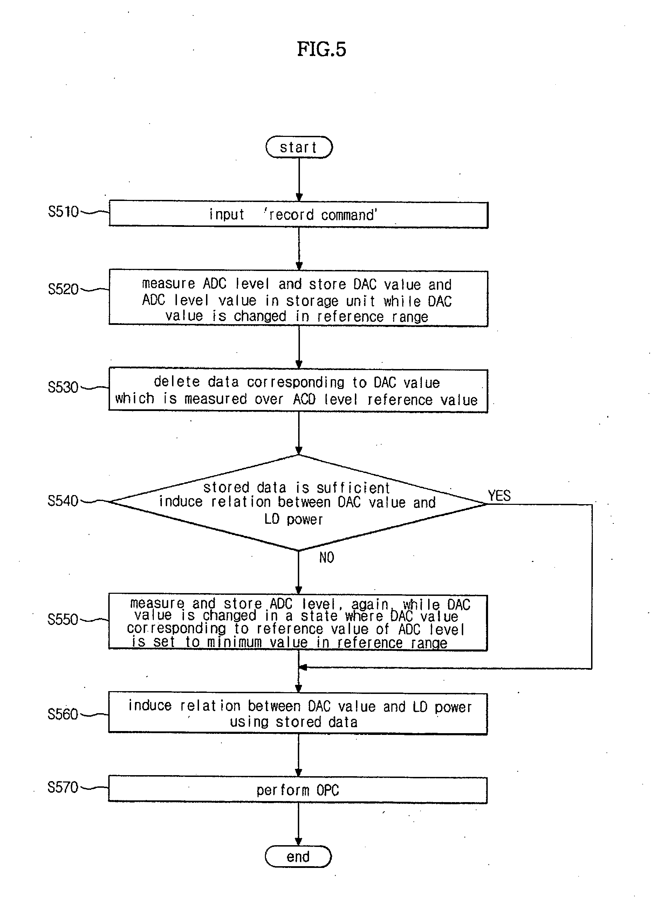

FIG. 5 is a flow chart describing a method for performing an optical power study of an optical disc apparatus according to an embodiment of the present invention. When a recordable optical disc is inserted into the optical disc apparatus and a recording command is inputted, a power study procedure is performed before performing an optimum power calibration (OPC) to calculate output characteristics of the LD 24, i.e., to calculate a relationship between the optical power control signal and the laser power, as shown in operation S510.

The controller 34 outputs optical power control signals to the DAC 36 in a reference range to measure the ADC level and to store the ADC level in the storage unit 35. The DAC value is a number which is transformed from the optical power control signal outputted from the DAC 36, and this number is generally expressed by a hexadecimal system, as shown in operation S520.

In order to exclude data in an interval in which laser power is saturated, a DAC value, whose ADC level is greater than a reference value (for example, when the reference voltage is 2.5V, the ACD digital steps are 775), along with data corresponding to the ADC level, are deleted from the storage unit 35, as shown in operation S530.

After this deletion, a determination is made as to whether the remaining data, is sufficient to calculate a relationship between the DAC value (optical power control signal) and the laser power of the LD, as shown in operation S540. This determination is made because a predetermined amount of data is needed to calculate the relationship between the optical power control signal and the laser power, as shown in operation S510.

When the determination of operation S540 is positive, or, in other words, when the remaining data is sufficient to calculate this relationship, the relationship is calculated using the stored data in operation S560.

On the other hand, when the determination of operation S540 is negative, or, in other words, when the remaining data is not sufficient to determine this relationship, the ADC level is measured again while the DAC values are changed in a predetermined reference range on the basis of the DAC value corresponding to a reference value, which is used as the minimum value, and then stored in the storage unit 35, as shown in operation S550.

Then, the relationship is calculated using the stored data, as shown in operation S560.

Afterwards, the OPC is performed on the basis of the calculated relation in operation S570.

As described above, the optical disc apparatus according to aspects of the present invention can prevent errors in the power study procedure when the laser power of a laser diode is saturated at a relatively high temperature.

Additionally, the optical disc apparatus can correctly obtain the result of the power study procedure, regardless of a change of temperature.

Furthermore, the optical disc apparatus can correctly perform the power study procedure at a relatively low temperature.

Although a few embodiments of the present invention have been shown and described, it would be appreciated by those skilled in the art that changes may be made in these embodiments without departing from , the scope of the invention which is defined in the claims.

## Claims

1. An optical disc apparatus comprising:
a laser output device (24) which outputs a laser beam in response to a light output control signal;
a sensor (20) which detects a portion of the outputted laser beam and then outputs a signal corresponding to the outputted laser beam;
a controller (34) which calculates output characteristics of the laser output device by excluding data corresponding to an interval in which laser power of the outputted laser beam stays constant; and
a first converter (32) which converts the output signal of the sensor to a digital signal corresponding to a predetermined resolution,
wherein the controller compares the digital signal with a predetermined reference value to determine whether the output power of the laser output device is in a saturated state, and wherein, if the output power of the laser output device is determined to be in the saturated state, the controller excludes the digital signal when the characteristics of the laser output power are calculated.

2. The apparatus as set forth in claim 1, wherein the controller determines that the laser output device is in the saturated state when the digital signal is greater than the reference value, and wherein, when the controller determines that the laser output device is in the saturated state, the controller applies a control signal corresponding to the predetermined reference value to use the control signal as a minimum control signal of a certain range, to the laser output device an additional time, and then calculates the characteristics of the laser output device.

3. The apparatus as set forth in claim 2, wherein the calculation of the output characteristics of the laser output power is performed when the digital signal indicates that the laser output device is not saturated.

4. The apparatus as set forth in claim 2 or 3, wherein the control signal of the certain range is a control signal corresponding to an erase power level of an optical disc.

5. The apparatus as set forth in any of claims 2-4, wherein the controller applies the control signal of the certain range to the laser output device in order to cause the laser output power to be sequentially increased.

6. The apparatus as set forth in any of claims 1= 5, wherein when excluding the excluded data results in an insufficient amount of remaining data to accurately calculate the output characteristics, the light output control signal is sequentially changed, using a control signal corresponding to a predetermined reference value as a minimum control signal of a certain range, and the output characteristics are calculated again to obtain sufficient data.

7. A method to calculate characteristics of output power of a laser output device mounted to an optical disc apparatus, comprising:
outputting a laser beam in response to a light output control signal;
detecting a portion of the outputted laser beam and then outputting a signal corresponding to the outputted laser beam;
calculating output characteristics of the laser output device by excluding data corresponding to an internal in which laser power of the outputted laser beam is constant;
wherein the laser power is constant when the laser power is in a saturated state,
the method further comprising:
converting the output signal corresponding to the outputted laser beam to a digital signal corresponding to a predetermined resolution;
comparing the digital signal with a predetermined reference value to determine whether the output power of the laser output device is in the saturated state; and
excluding the digital signal when the characteristics of the output power are calculated if the output power of the laser output device is determined to be in the saturated state.

8. The method as set forth in claim 7, further comprising:
determining that the laser output device is in the saturated state when the digital signal is greater than the predetermined reference value;
using a control signal corresponding to the predetermined reference value as a minimum control signal of a certain range when a controller determines that the laser output device is in the saturated state; and
repeating the calculation of the characteristics of the laser output device using the minimum control signal.

9. The method as set forth in claim 8, further comprising the calculating of the output characteristics of the laser output power when the digital signal indicates that the laser output device is not saturated.

10. The method as set forth in claim 9, wherein the control signal of the certain range is a control signal corresponding to an erase power level of an optical disc.

11. The method as set forth in claim 9 or 10, further comprising sequentially increasing the laser output power by applying the control signal of the certain range to the laser output device.

## Patentansprüche

1. Optische Plattenvorrichtung, umfassend:
eine Laserausgabeeinrichtung (24), die einen Laserstrahl in Reaktion auf ein Lichtausgabesteuerungssignal ausgibt;
einen Sensor (20), der einen Abschnitt des ausgegebenen Laserstrahls erfasst und dann ein dem ausgegebenen Laserstrahl entsprechendes Signal ausgibt;
eine Steuerungseinrichtung (34), welche Ausgabecharakteristiken der Laserausgabeeinrichtung berechnet, indem sie Daten ausschließt, die einem Intervall entsprechen, in dem die Laserleistung des ausgegebenen Laserstrahls konstant bleibt; und
einen ersten Wandler (32), der das Ausgangssignal des Sensors zu einem digitalen Signal entsprechend einer vorbestimmten Auflösung wandelt,
wobei die Steuerungseinrichtung das digitale Signal mit einem vorbestimmten Bezugswert vergleicht, um festzustellen, ob sich die Ausgabeleistung der Laserausgabeeinrichtung in einem gesättigten Zustand befindet, und wobei, falls festgestellt wird, dass sich die Ausgabeleistung der Laserausgabeeinrichtung im gesättigten Zustand befindet, die Steuerungseinrichtung das digitale Signal ausschließt, wenn die Charakteristiken der Laserausgabeleistung berechnet werden.

2. Vorrichtung nach Anspruch 1, wobei die Steuerungseinrichtung feststellt, dass sich die Laserausgabeeinrichtung im gesättigten Zustand befindet, wenn das digitale Signal größer ist als der Bezugswert, und wobei, wenn die Steuerungseinrichtung feststellt, dass sich die Laserausgabeeinrichtung im gesättigten Zustand befindet, die Steuerungseinrichtung ein dem vorbestimmten Bezugswert entsprechendes Steuerungssignal, zwecks Verwendens des Steuerungssignals als Mindeststeuerungssignal aus einem bestimmten Bereich, an die Laserausgabeeinrichtung ein zusätzliches Mal anlegt, und dann die Charakteristiken der Laserausgabeeinrichtung berechnet.

3. Vorrichtung nach Anspruch 2, wobei die Berechnung der Ausgabecharakteristiken der Laserausgabeleistung vorgenommen wird, wenn das digitale Signal anzeigt, dass die Laserausgabeeinrichtung nicht gesättigt ist.

4. Vorrichtung nach Anspruch 2 oder 3, wobei das Steuerungssignal aus dem bestimmten Bereich ein Steuerungssignal ist, das einem Löschleistungspegel einer optischen Platte entspricht.

5. Vorrichtung nach einem der Ansprüche 2 - 4, wobei die Steuerungseinrichtung das Steuerungssignal aus dem bestimmten Bereich an die Laserausgabeeinrichtung anlegt, um zu bewirken, dass die Laserausgabeleistung sequenziell erhöht wird.

6. Vorrichtung nach einem der Ansprüche 1 - 5, wobei, wenn das Ausschließen der ausgeschlossenen Daten in einer Menge verbleibender Daten resultiert, die nicht ausreicht, um die Ausgabecharakteristiken exakt zu berechnen, das Lichtausgabesteuerungssignal sequenziell verändert wird, wobei ein Steuerungssignal, das einem vorbestimmten Bezugswert entspricht, als Mindeststeuerungssignal aus einem bestimmten Bereich verwendet wird, und die Ausgabecharakteristiken erneut berechnet werden, um ausreichende Daten zu erhalten.

7. Verfahren zum Berechnen von Charakteristiken der Ausgabeleistung einer an einer optischen Plattenvorrichtung montierten Laserausgabeeinrichtung, umfassend:
Ausgeben eines Laserstrahls in Reaktion auf ein Lichtausgabesteuerungssignal;
Erfassen eines Abschnitts des ausgegebenen Laserstrahls und dann Ausgeben eines Signals, das dem ausgegebenen Laserstrahl entspricht;
Berechnen von Ausgabecharakteristiken der Laserausgabeeinrichtung durch Ausschließen von Daten, die einem Intervall entsprechen, in dem die Laserleistung des ausgegebenen Laserstrahls konstant ist;
wobei die Laserleistung konstant ist, wenn sich die Laserleistung in einem gesättigten Zustand befindet,
das Verfahren weiterhin umfassend:
Wandeln des Ausgangssignals, das dem ausgegebenen Laserstrahl entspricht, zu einem digitalen Signal entsprechend einer vorbestimmten Auflösung;
Vergleichen des digitalen Signals mit einem vorbestimmten Bezugswert, um festzustellen, ob sich die Ausgabeleistung der Laserausgabeeinrichtung im gesättigten Zustand befindet; und
Ausschließen des digitalen Signals, wenn die Charakteristiken der Ausgabeleistung berechnet werden, falls festgestellt wird, dass sich die Ausgabeleistung der Laserausgabeeinrichtung im gesättigten Zustand befindet.

8. Verfahren nach Anspruch 7, weiterhin umfassend:
Feststellen, dass sich die Laserausgabeeinrichtung im gesättigten Zustand befindet, wenn das digitale Signal größer ist als der vorbestimmte Bezugswert;
Verwenden eines Steuerungssignals, das dem vorbestimmten Bezugswert entspricht, als Mindeststeuerungssignal aus einem bestimmten Bereich, wenn eine Steuerungseinrichtung feststellt, dass sich die Laserausgabeeinrichtung im gesättigten Zustand befindet; und
Wiederholen der Berechnung der Charakteristiken der Laserausgabeeinrichtung mittels des Mindeststeuerungssignals.

9. Verfahren nach Anspruch 8, weiterhin umfassend das Berechnen der Ausgabecharakteristiken der Laserausgabeleistung, wenn das digitale Signal anzeigt, dass die Laserausgabeeinrichtung nicht gesättigt ist.

10. Verfahren nach Anspruch 9, wobei das Steuerungssignal aus dem bestimmten Bereich ein Steuerungssignal ist, das einem Löschleistungspegel einer optischen Platte entspricht.

11. Verfahren nach Anspruch 9 oder 10, weiterhin umfassend das sequenzielle Erhöhen der Laserausgabeleistung durch Anlegen des Steuerungssignals aus dem bestimmten Bereich an die Laserausgabeeinrichtung.

## Revendications

1. Appareil pour disque optique comprenant :
un dispositif d'émission laser (24) qui émet un faisceau laser en réponse à un signal de commande d'émission lumineuse ;
un capteur (20) qui détecte une partie du faisceau laser émis, puis émet un signal correspondant au faisceau laser émis ;
un dispositif de commande (34) qui calcule les caractéristiques d'émission du dispositif d'émission laser en excluant des données correspondant à un intervalle dans lequel la puissance laser du faisceau laser émis reste constante ; et
un premier convertisseur (32) qui convertit le signal de sortie du capteur en un signal numérique correspondant à une résolution prédéterminée,
dans lequel le dispositif de commande compare le signal numérique à une valeur de référence prédéterminée afin de déterminer si la puissance d'émission du dispositif d'émission laser est dans un état de saturation, et dans lequel, s'il est déterminé que la puissance d'émission du dispositif d'émission laser est en état de saturation, le dispositif de commande exclut le signal numérique lors du calcul des caractéristiques de la puissance d'émission laser.

2. Appareil selon la revendication 1, dans lequel le dispositif de commande détermine que le dispositif d'émission laser est en état de saturation lorsque le signal numérique est supérieur à la valeur de référence, et dans lequel, lorsque le dispositif de commande détermine que le dispositif d'émission laser est dans un état de saturation, le dispositif de commande applique au dispositif d'émission laser, une fois supplémentaire, un signal de commande correspondant à la valeur de référence prédéterminée, en utilisant le signal de commande comme signal de commande minimum de la certaine gamme, puis calcule les caractéristiques du dispositif d'émission laser.

3. Appareil selon la revendication 2, dans lequel le calcul des caractéristiques d'émission de la puissance d'émission laser est effectué lorsque le signal numérique indique que le dispositif d'émission laser n'est pas saturé.

4. Appareil selon la revendication 2 ou 3, dans lequel le signal de commande de la certaine gamme est un signal de commande correspondant à un niveau de puissance d'effacement d'un disque optique.

5. Appareil selon l'une quelconque des revendications 2 à 4, dans lequel le dispositif de commande applique le signal de commande de la certaine gamme au dispositif d'émission laser afin d'entraîner l'augmentation séquentielle de la puissance d'émission laser.

6. Appareil selon l'une quelconque des revendications 1 à 5, dans lequel lorsque l'exclusion des données exclues se traduit par une quantité insuffisante de données restantes pour calculer précisément les caractéristiques d'émission, le signal de commande d'émission lumineuse est modifié séquentiellement en utilisant un signal de commande correspondant à une valeur de référence prédéterminée comme signal de commande minimum d'une certaine gamme, et les caractéristiques d'émission sont calculées à nouveau pour obtenir des données suffisantes.

7. Procédé de calcul des caractéristiques de la puissance d'émission d'un dispositif d'émission laser monté sur un appareil pour disque optique, comprenant :
l'émission d'un faisceau laser en réponse à un signal de commande d'émission lumineuse ;
la détection d'une partie du faisceau laser émis puis l'émission d'un signal correspondant au faisceau laser émis ;
le calcul des caractéristiques d'émission du dispositif d'émission laser en excluant les données correspondant à un intervalle dans lequel la puissance laser du faisceau laser émis est constante,
la puissance laser étant constante lorsqu'elle se trouve dans un état de saturation,
le procédé comprenant en outre :
la conversion du signal de sortie correspondant au faisceau laser émis, en un signal numérique correspondant à une résolution prédéterminée ;
la comparaison du signal numérique à une valeur de référence prédéterminée afin de déterminer si la puissance d'émission du dispositif d'émission laser est en état de saturation ; et
l'exclusion du signal numérique lors du calcul des caractéristiques de la puissance d'émission s'il est déterminé que la puissance d'émission du dispositif d'émission laser est en état de saturation.

8. Procédé selon la revendication 7, comprenant en outre :
la détermination du fait que le dispositif d'émission laser soit en état de saturation lorsque le signal numérique est supérieur à la valeur de référence prédéterminée ; l'utilisation d'un signal de commande correspondant à la valeur de référence prédéterminée comme signal de commande minimum d'une certaine gamme lorsqu'un dispositif de commande a déterminé que le dispositif d'émission laser est en état de saturation ; et
la réitération du calcul des caractéristiques du dispositif d'émission laser en utilisant le signal de commande minimum.

9. Procédé selon la revendication 8, comprenant en outre le calcul des caractéristiques d'émission de la puissance d'émission laser lorsque le signal numérique indique que le dispositif d'émission laser n'est pas saturé.

10. Procédé selon la revendication 9, dans lequel le signal de commande de la certaine gamme est un signal de commande correspondant à un niveau de puissance d'effacement d'un disque optique.

11. Procédé selon la revendication 9 ou 10, comprenant en outre l'augmentation séquentielle de la puissance d'émission laser en appliquant le signal de commande de la certaine gamme au dispositif d'émission laser.
